# EUROPEAN PATENT APPLICATION

(11) **EP 3 252 006 A1**
(43) Date of publication of application: **06.12.2017**
(21) Application number: 16705990.6
(22) Date of filing: 18.01.2016
(51) Int. Cl.: C01B 33/037, C30B 13/00, C22B 9/22

(54) **A METHOD AND APPARATUS FOR VACUUM PURIFICATION OF SILICON**

(30) Priority: 26.01.2015 LV 150008 P
(71) Applicant: Kravtsov, Anatoly, 1011 Riga (LV)
(72) Inventor: Kravtsov, Anatoly, 1011 Riga (LV)
(74) Representative: Zaboliene, Reda
(86) International application number: PCT/IB2016/050225
(87) International publication number: WO 2016/120747

(57) **Abstract**

The suggested inventions solve problems of producing high-purity silicon, enhancing purification performance, reducing energy and material costs and growing source rods used in float-zone melting.

The technical results are as follows: the speed of silicon purification by vacuum evaporation from impurities with a vapour pressure higher than that of silicon is increased, the contamination of purified silicon with impurities from equipment at temperatures close to the silicon melting point is eliminated, and the purified melt is pulled forming desired rod along with final crystallised purification of the melt.

The technical result is achieved by the fact that the method of ingot growing from the melt involves the melting of the charge using at least two electron beams in a cooled device equipped with heat insulator, which provides various levels of heat transfer from the melt to the cooled device in its different parts, formation of circular zone of beams affecting the surface of the melt by way of electron beam scanning and seeded pulling of an ingot of set diameter. Purification is ensured before pulling by feeding the charge in portions and exposing the melt to reduced pressure. The process is controlled by changing the pulling speed, input energy amounts, as well as the position and width of the circular heating zone, which intensifies the purification process by frequent periodic stirring of the melt. The whole cycle is repeated with pulled ingot removed from the plant.

## Description

The group of inventions relates to the production of silicon, for example, for the industrial production of silicon for the photoelectric industry including the manufacturing of solar cells. The purpose of this manufacturing process is to obtain solar grade silicon from a variety of cheaper sources of raw materials, including recycled materials, which require additional purification.

### Prior Art

In accordance with the Inventor's Certificate No. 159293, published 07.12.1963 [1], there is a device, which creates the exact circular heating zone using a few (6-8) electron beam guns (EBG) with focusing (deflecting) plates in the form of the arc and linear wire cathodes for float-zone melting of silicon in pulling furnaces by Czochralski method in order to achieve a uniform thermal field. When the diameter of grown crystals increased, such solution leads to unnecessarily high costs of appliances equipped with a large number of power supply sources for EBG, besides getting the native silicon for growing the crystal of more than the required diameter (greater than 40 mm) is almost impossible, as shown in the article by T.F. Ciszek "GROWTH OF 40 mm DIAMETER SILICON CRYSTALS BY A PEDESTAL TECHNIQUE USING ELECTRON BEAM HEATING", published in "Journal of crystal growth" No. 12 (1972), page 281-287 [2].

In accordance with the Patent No. RU 2 403 299, published 10.11.2010 [3], there is a method of vacuum purification of silicon involving loading of purified silicon into quartz crucible placed in water-cooled device containing a thermal insulator. Silicon is melted by electron-beam heating and then the melt is soaked in order for impurities and their compounds to evaporate by heating the local area of the melt surface with electron beam along with dissipation of heat from the top part of the bed at the level of the melt surface. During the soaking process, the temperature of the melt is reduced from time to time and then it is stirred and heated to the required temperature. After soaking, a directed crystallisation of purified silicon is exercised. This method is to be implemented in the device containing the vacuum chamber, quartz tool for stirring the melt, quartz crucible with purified silicon and electron-beam gun mounted above the crucible and able to direct an electron beam to the local area of the silicon melt surface. Quartz crucible is placed in alignment with the refrigerator and the cooled device, from which is separated by a thermal insulator with a melting point not lower than the melting temperature of quartz crucible. Disadvantages of the said method and device are lack of the ability to grow an ingot or other way to remove the purified melt to run the semi-continuous process of purification.

In accordance with the Patent No. No. 4350560 (US), published 21.09.1982 [4], there is a device and a method of its application, consisting of the melting chamber with quartz crucible and the upper chamber hosting grown ingot and separated from the melting chamber by vacuum valve. The upper chamber is equipped a drive for pulling the seed and moving the grown ingot to the upper chamber. After pulling, the ingot is fully placed to and fixed in the upper chamber, then the chambers are separated with a vacuum valve and the upper chamber is moved to a set position, then the grown ingot is removed, after which the machine state is restored and it is ready again for the ingot growing from the melt. It is obvious that the mentioned device can be used for feeding the new portion of the source material to the melting chamber and removal of the ingot and the material feed for the processing can take place through a door provided the upper chamber is equipped with one. Along with the ability of the mentioned Patent to implement semi-continuous processing of source material that can be heated in a variety of ways including electron beam method, it lacks description of the methods of managing the electron beams, cooled device, apparatus for mixing the melt during purification, etc.

The closest analogue to the proposed invention is the method of growing a single crystal from the melt known from patent No. 3494804 (US), published 10.02.1970 [4], in which at least three focused arc-shaped electron beams are directed onto a given area of the melt surface mainly of the ring form with a diameter 3-4 times greater than the diameter of the pulled ingot. Then the seed crystal (seed) and melt are connected and an ingot is grown. In addition, this method provides the regulation of beams' power, the radius of the ring zone and pulling speed to control feeding of additional material or alloying additives into the melt outside the ring heating zone. The method involves using as source material both the rod of diameter larger than the diameter of the growing ingot and a water-cooled copper device in which the melt is formed. Disadvantages of this method are:
a) infeasibility in a case of using the original ingot of larger diameter for growing ingots of modern sizes (150-300 mm), because the maximum diameter of the polycrystalline silicon rods used for this process is currently not exceeding 175 mm.
b) while growing such ingots using the cooled crucible with skull, a central part of the skull uncontrollably approaches closer to growing ingot and aligns with it, as shown in source [2]. Moreover, the method does not provide opportunities for effective vacuum purification or handling of the melt using reaction gases, because silicon stays in the molten state for insignificant amount of time and is immediately pulled.

### Purpose and technical character of the invention

The suggested inventions solve problems of producing high-purity silicon, enhancing purification performance, reducing energy and material costs and growing source rods used in float-zone melting.

The technical results are as follows: the speed of silicon purification by vacuum evaporation from impurities with a vapour pressure higher than that of silicon is increased, the contamination of purified silicon with impurities from equipment at temperatures close to the silicon melting point is eliminated, and the purified melt is pulled forming desired rod along with final crystallised purification of the melt.

The technical result is achieved by the fact that the method of ingot growing from the melt involves the melting of the charge using at least two electron beams in a cooled device equipped with heat insulator, which provides various levels of heat transfer from the melt to the cooled device in its different parts, formation of circular zone of beams affecting the surface of the melt by way of electron beam scanning and seeded pulling of an ingot of set diameter. Purification is ensured before pulling by feeding the charge in portions and exposing the melt to reduced pressure. The process is controlled by changing the pulling speed, input energy amounts, as well as the position and width of the circular heating zone, which intensifies the purification process by frequent periodic stirring of the melt. The whole cycle is repeated with pulled ingot removed from the plant.

The technical character of the method is that the purified silicon is fed in portions into the cooled device that contains a thermal insulator, melted using electron beam, and soaked each portion of the melt to evaporate the impurities in a vacuum, then add a new portion to the purified batch and then perform seeded pulling of the cylindrical shape rod. At considerable height of the bed, it is hard to ensure surface purification of the whole amount of the melt, especially given the top heating and short purification time when pulling the melt immediately after melting. Therefore, seeding of the melt under reduced pressure is carried out before growing - during this process, heating is concentrated in the focal spot located in the centre of the melt surface. Depth of portions of the purified melt does not exceed 90% of the depth of electron beam penetration, typical for the created thermal system and selected value of the total power supply capacity. The purification process is intensified by periodically stirring the melt. To remove contaminants, "seeding-mixing" cycle is repeated many times - at least 3 times. When pulling, the heating is performed by at least two electron-beam heating circuits that use focused rays to generate focal heating spots moving along the arcs of the set radius that is larger than the diameter (2 radii) of the growing rod. Width of the ring heating zone is determined by the diameter of the focal spot. Thermal conditions for sequential implementation of the purification and growing processes are provided by optimising heat transfer from the melt to the cooled device through properties and geometric dimensions of heat insulator. After the first (or subsequent) purification cycle, cylindrical rod is removed from the device and the process is repeated. Except for the last one, the grown rod must have a mass of not more than 85% of the original bed in order to ensure safe and sufficient level of melt for feeding new portions of purified silicon.

An apparatus with at least two chambers and separate means of vacuum pumping is used for growing, in which a loading and unloading chamber, separated from the melting chamber by vacuum valve, a device for lifting and rotating of a seed and at least two electron-beam guns (EBG) are located above the vacuum melting chamber that contains the cooled device with heat insulator and the melt. The apparatus includes removable devices for the mixing of the melt using a high-melting compound of the purified material as a working tool and a device for additional loading.

EBG's have a water-cooled cathode and two annular electromagnetic lenses each that are spaced-apart in the axial direction along the path of the electron beam. In addition, EBG's are equipped with control and monitoring devices for simulation of the beams' motion patterns and width of the ring heating zone created by them, in particular the location of centres and radii of circles, which arcs form a ring heating zone. The cooled unit is equipped with thermal insulator with a melting point of not less than 15% above the melting point of treated silicon.

### Brief description of the drawings

Figure 1. Feeding the first portion of silicon to be purified:
Figure 2. Feeding the second portion of silicon to be purified:
Figure 3. Purification apparatus and equipment used in-process;
Figure 4. Top view of the heat unit at the various stages of the process;
Figure 5. Diagram of the growing process.

### Detailed Description of the Invention

The method is implemented as follows.

Thermal insulator is placed inside the cooled device, followed by the first portion of silicon containing impurities. Then the cooled device is installed into the melting chamber of the apparatus with subsequent creation of a vacuum followed by melting utilising electron-beam heating. After melting, the electron beam is focused at minimum surface area of melt in the local area and seeded over a period of time for removal of melt impurities with a vapour pressure higher than that of silicon. The purification process is intensified by periodically stirring the melt. Removal of harmful impurities is provided by multiple cyclic repetition of steps above. Then, using the machine for additional loading, the cooled device is fed with a new batch of source material and the purification process is repeated as described above. After vacuum purification of the required amount of source material, the stirring device is lifted up into the loading-unloading chamber and replaced with the seed crystal. The rays are spread to a specified diameter and scanning is started, forming a ring heating zone. Then the seed crystal is lowered; it connects with the melt and grows into the rod of specified diameter. The growing process is controlled by modifying the speed of pulling, diameter of the ring area and intensity of heating, while supporting the diameter of the ring heating zone 2 times larger than the diameter of the growing rod. Scan trajectories together form the shape of a ring close to the ring of the required diameter and form the thermal field of sufficient thermal symmetry for growing a cylindrical rod. Thermal conditions for sequential implementation of the purification and growing processes are provided by optimising heat transfer from the melt to the cooled device through properties and geometric dimensions of heat insulator. In particular configuration of the heating zone, three heat-sinking currents emerge: to the bottom and side surface of the cooled device and radiation from the surface of the melt. The main challenge of the growing process is to establish the right balance between these three variables. In case of great heat dissipation to the bottom side of the cooled device and large diameter of the growing ingot an effect occurs, described in [2], namely: the central part of the processed silicon forms a ledge against the melt and touches the growing ingot causing it to attach to the native silicon and resulting in abnormally ended process. The use of heat insulator that at least twice reduces the heat dissipation to the bottom of the cooled device allows to solve that problem - in particular, by increasing the layer of homogeneous heat insulator at least 2 times. After the first purification cycle, cylindrical rod is removed from the device and the process is repeated. Grown rod weighing not more than 85% of the original load is fully raised into the loading-unloading chamber and removed after cooling. That rod is replaced with the device for additional loading, in which a new batch of silicon to be purified is fed in an amount not exceeding the calculated amount of the melt with depth of 90% of the depth of electron beam penetration typical for established heat system, and then the purification process is repeated as described above.

### 1. An example of implementation of this method

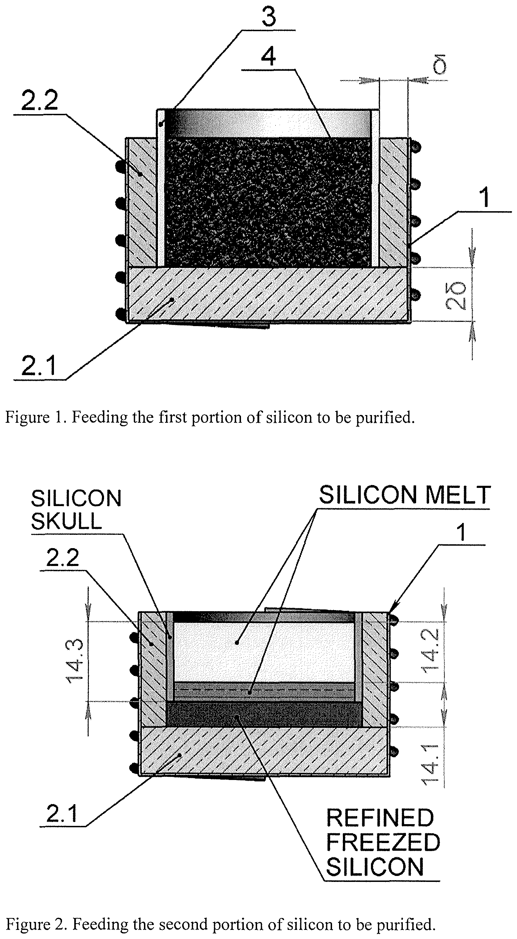

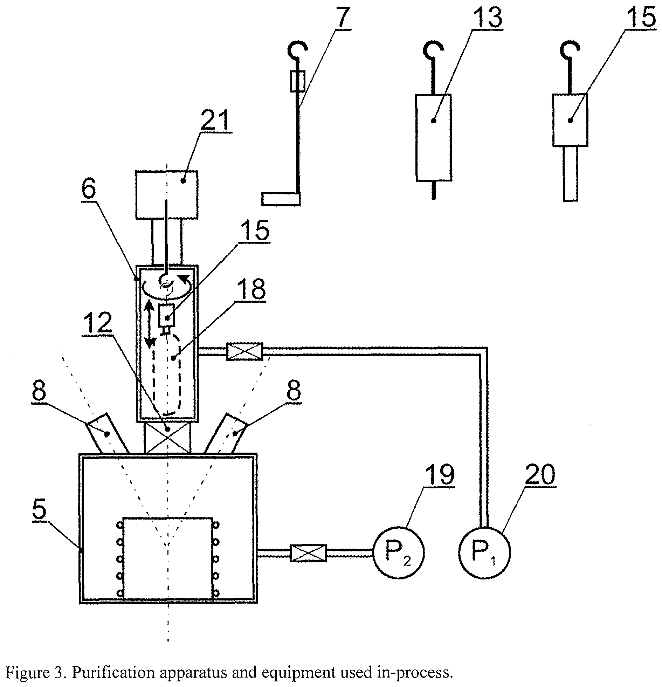

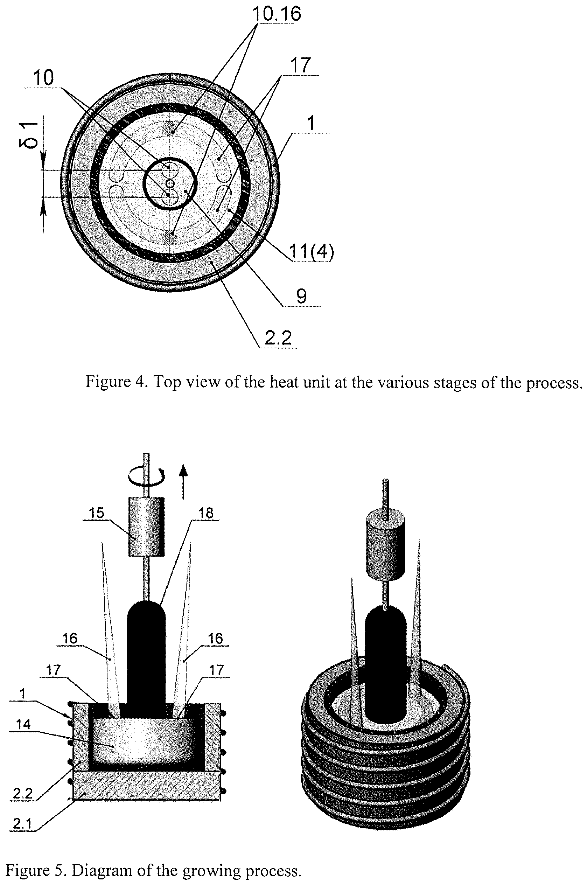

A layer of heat insulator (2.1) is placed in the bottom part of the cooled device (1) (Figure 1). Then, a mould (3) is mounted on the layer of heat insulator in the form of a metal shell. The same thermal insulator (2.2) is placed between the mould and the tank, with the layer of heat insulator in the bottom part is at least 2 times thicker. Silicon (4) is loaded inside the mould and then the mould is removed. Thus a cooled device (Figure 3) prepared in such a manner is placed into the bottom chamber (5) of the two-chambered apparatus. A stirring device (7) is placed into the upper chamber (6) in the form of a curved quartz rod. Then, the apparatus is vacuumised. After reaching the required residual pressure, both EBG (8) are switched on and silicon is melted. After the melting (Figure 4), electron beams with the total capacity of 1.2 - 2.0 kW per 1 kg of loaded silicon are concentrated on the minimum area of the melt surface in the local segment (9). The distance between the focal spots (10) on the surface in which power transmitted by electrons to the melt (11) is concentrated approximately equals to one-tenth of the mould diameter (3) (fig. 1). Melt is seeded for 30-60 minutes, ensuring the removal of impurities with a vapour pressure higher than that of silicon. The purification process is intensified by periodic stirring of the melt, for example, once per hour. In order to do this, focal spots are moved away from the quartz rod diving sites, then the power supplied is reduced by 20-40%, then the melt is stirred for 3-7 minutes and then heated again. Removal of harmful impurities is provided by multiple, such as x5, repeating of the cycle. Then the stirring device (7) (Figure 3) is raised into the upper chamber (6), the vacuum valve (12) between the chambers is closed and atmospheric pressure is created in the upper chamber. After cooling, the stirring device (7) is replaced with the device for additional loading (13) that contains the right amount of silicon. The upper chamber (6) is vacuumised, followed by opening of the vacuum valve (12), reducing of the EBG power by 50-60% and unloading of the silicon from the loading device (13). The amount of silicon (Figure 2) is selected so the thickness of a layer of the melt (14.2) in a molten state formed by added silicon did not exceed 90% of the depth of electron beam penetration typical for established heat system, and then the purification process is repeated as described above. In this way, the combination of previously purified (14.1) and new batches of silicon is ensured. After vacuum purification of the required amount of source material, the stirring device is lifted up into the loading-unloading chamber (6), the vacuum valve (12) is closed and then the device is replaced with the seed crystal (15).

The rays (16) are spread to a specified diameter and scanning is started, forming a ring heating zone (17). The seed crystal (15) is lowered, connected with the melt and grown into the rod (18) of the required diameter (Figure 5). The diameter of the ring heating zone is maintained more than 2 times larger than diameter of the growing rod. The grown rod (18) weighing not more than 85% of the original load is fully lifted into the loading and unloading chamber (6), then the vacuum valve (12) between the chambers is closed, and then the cooled rod is extracted and the device for additional loading (13) is mounted in which a new batch of silicon to be purified is fed. Then the vacuum is created in the loading-unloading chamber (6), the valve (12) between the chambers is opened and a new portion of the source material is fed into the cooled device by using the device for additional loading (13). The whole process is repeated 3-5 times. If the mass of the cylindrical rod is more than 85% of the original bed, the speed of growing is dropping and the likelihood of destruction of the formed heat insulator (2) is increasing unreasonably at the end of the process when feeding new portions of silicon to be purified. At the same time, a significant reduction in the mass of the cylindrical rod, for example to less than 70% of the original bed, leads to unnecessary reduction of the process performance and over-expenditure of electricity to maintain the melt residue during cooling of the grown rod. If the mass of silicon loaded in a single session, except the first one, is more than needed for the formation of a melt layer of 90% of the depth of electron beam penetration, it may result in uneven melt purification and formation of the zones of low specific electrical resistance on the grown rod. At the same time, a load of less than 80% significantly reduces the performance of the process.

To implement this method, an apparatus with at least two chambers and separate means of vacuum pumping (19,20) is used, in which a loading and unloading chamber (6), separated from the melting chamber by vacuum valve (12) and equipped with a drive for lifting and rotation of a seed (21) is located above the vacuum melting chamber (5). The cooled device (1) with heat insulator (2) and the melt (14) is located in the melting chamber of the apparatus, and at least two EBG's (22) are mounted outside the upper part of the chamber. The apparatus includes removable devices for the mixing of the melt (7) using quartz (23) as a working tool and a device for additional loading (13). Removable devices are powered by the drive for seed lifting and rotating (21). Cooling of the device with heat insulator and the melts is made by water.

EBG's have a water-cooled cathode (24) and a couple of annular electromagnetic lenses each (25, 26) that are spaced-apart in the axial direction along the path of the electron beam. EBG's are equipped with a means of monitoring and controlling of beam trajectories and the size of ring heating zone created by them. In particular, positions of the centres and radii of circles are set and monitored, arcs of which form the ring heating zone and the radii of these circles. The cooled unit is equipped with thermal insulator (2) with a melting point of not less than 15% above the melting point of treated silicon. Also, silicon placed inside the cooled device is separated from it by the heat insulator, a layer of which between the bottom and silicon (2.1) is twice the layer between silicon and the side wall of the cooled devices (2.2).

## Claims

1. A method of vacuum purification of silicon involving melting silicon with an electron beam, seeding of the melt to vaporise contaminants in vacuum and directed crystallisation of silicon to be purified is **characterised in that** the original charge is fed in portions, and when a new batch is added to the purified amount every portion of the melt is purified and then seeded pulling of the cylindrical rod is performed under the set heat transfer from the melt to the cooled device in which it is located.

2. The method, in accordance with paragraph 1, is **characterised in that** during pulling of the cylindrical rod, heating is performed by at least two electron-beam heating circuits, creating mobile heat spots moving in the arcs of the specified radius of not less than two times larger than the diameter of the growing rod, and designed heat transfer from the melt to the cooling device is distributed so that heat transfer to the bottom part of the cooled device is not less than 2 times lower than heat transfer to its side surface.

3. The method, in accordance with paragraph 1 and/or 2, is **characterised in** than portions of the depth of the melt to be purified does not exceed 90% of the depth of electron beam penetration and the pulled rod, except for the last one, has a mass of not more than 85% of the original bed.

4. The double-chamber apparatus with separate means of creation of a vacuum in the chambers and a valve between them, in which a loading and unloading chamber and a device for lifting and rotation of a seed are located above the vacuum melting chamber, and the melting chamber is equipped with at least two electron beam guns with a water-cooled cathodes and tools to control the movement of the beam mounted above the cooled device containing silicon and thermal insulator, is **characterised in that** the heat insulator in the bottom part has at least twice the thickness of the heat insulator on the side of the melt and is made of a material with a melting point of at least 15% higher than the melting point of silicon.
